## Europäisches Patentamt

## European Patent Office

## Office européen des brevets

(19)

(11) Numéro de publication: **0 194 225 B1**

(12) **FASCICULE DE BREVET EUROPEEN**

(45) Date de publication du fascicule du brevet:
27.09.89

(21) Numéro de dépôt: 86810018.1

(22) Date de dépôt: 17.01.86

(51) Int. Cl.⁴: **H 01 F 40/06**, G 01 R 15/02

(54) Transformateur d'intensité pour courant continu et alternatif.

(30) Priorité: 05.02.85 CH 499/85

(43) Date de publication de la demande:
10.09.86 Bulletin 86/37

(45) Mention de la délivrance du brevet:
27.09.89 Bulletin 89/39

(84) Etats contractants désignés:
DE FR GB IT

(56) Documents cités:
DE-A- 2 224 618

PATENTS ABSTRACTS OF JAPAN, vol. 8, no. 66 (E-234)
[1503], 28 mars 1984; & JP - A - 58 216 412 (SANEISHIYA
SEISAKUSHO K.K.) 16-12-1983
Idem
PATENTS ABSTRACTS OF JAPAN, vol. 4, no. 109 (E-20)
[591], 6. août 1980, page 8 E 20; & JP - A - 55 65 418
(TOKYO SHIBAURA DENKI K.K.) 16-05-1980

(73) Titulaire: LEM SA, 140 chemin du Pont-du-Centenaire,
CH-1228 Plan-les-Ouates Genève (CH)

(72) Inventeur: Cattaneo, Pierre, F-74160 Collonges s/Saleve
(FR)

(74) Mandataire: Ardin, Pierre, PIERRE ARDIN & CIE 22, rue
du Mont-Blanc Case postale 60, CH-1211 Genève 1 (CH)

ACTORUM AG

## Description

On connaît déjà du document DE-A-2 224 618 des capteurs d'intensité pour courants continus et alternatifs, comprenant un circuit magnétique constitué par une carcasse possédant un entrefer et portant deux enroulements, un élément à effet HALL étant sensible au champ magnétique régnant dans l'entrefer, cet élément fournissant un signal électrique dépendant du champ magnétique, un amplificateur contrôlé par ledit signal, cet amplificateur alimentant l'un des deux enroulements dans un sens tel qu'il tende à annuler le champ magnétique qui donne naissance audit signal électrique, un dispositif de mesure de courant étant branché en série avec l'enroulement alimenté par l'amplificateur.

On connaît egalement des transformateurs d'intensité, par exemple selon le document JP-A-58 216 412, dont l'élément de base est constitué pour un noyau magnétique A et par un enroulement. Pour permettre la mesure d'un courant alternatif de faible intensité et jusqu'a une très forte intensité, on a ajouté an noyau A, sous entrefer et à haute permeabilité, un noyau B à faible perméabilité et présentant un entrefer et dont la saturation magnétique nese produit que pour des courants beaucoup plus fort que ceux provoquant la saturation du noyau A. Dans ce document, le problème de la fréquence n'est pas abordé.

Les capteurs de ce genre donnent entière satisfaction pour la mesure des courants continus ainsi que pour les courants alternatifs de fréquence relativement basse. Toutefois lorsque la fréquence des courants alternatifs augmente, la réponse du système diminue principalement en raison du flux de fuite dû à l'entrefer, d'une part et en fonction de la réponse en fréquence de l'amplificateur d'autre part.

La présente invention a pour but d'améliorer les performances dynamiques des transformateurs d'intensité du type précité. Ce résultat est obtenu grâce au fait que le circuit magnétique comprend un deuxième noyau ferromagnétique dépourvu d'entrefer, ce deuxième noyau étant couplé magnétiquement au premier noyau par lesdits enroulements.

Le dessin annexé montre un dispositif connu et, à titre d'exemple, une forme d'exécution du dispositif objet de l'invention.

La fig. 1 représente le dispositif connu.

La fig. 2 représente ladite forme d'exécution.

La fig. 3 est un diagramme de la courbe de réponse du transformateur de la fig. 1.

La fig. 4 est un diagramme de la courbe de réponse du transformateur de la fig. 2.

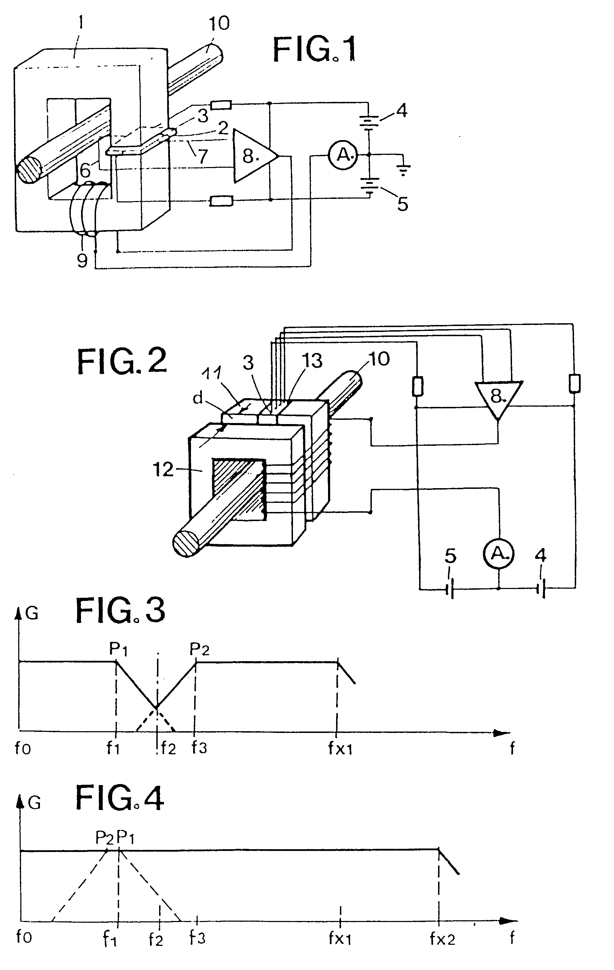

Dans le dispositif connu, illustré à la fig. 1, le capteur comprend un noyau 1 ferromagnétique de forme rectangulaire. Ce noyau 1 présente un entrefer 2 dans lequel est disposé un élément 3 sensible au champ magnétique régnant dans cet entrefer. Cet élément 3 peut être notamment constitué par une cellule à effet HALL. Cette cellule est alimentée par un courant fourni par deux batteries 4 et 5 montées en série et dont le point de connexion est relié à la terre. Lorsque la cellule 3 est placée dans un champ magnétique transversal à son plan, elle donne naissance à une tension entre deux électrodes 6 et 7 disposées perpendiculairement par rapport au courant qui la traverse. Cette tension est appliquée à un amplificateur 8 dont le gain est très élevé et dont la sortie alimente un enroulement secondaire 9 qui entoure le noyau 1. Au dessin, on a représenté cet enroulement 9 sur une branche différente de celle contenant la cellule 3 pour plus de clarté, mais en principe, cet enroulement secondaire est disposé sur la branche dans laquelle se trouve la cellule 3.

Dès qu'un champ magnétique agit sur la cellule 3, l'amplificateur fait circuler dans l'enroulement 9 un courant qui doit en annuler le champ magnétique produisant ladite tension et dû au passage du courant dans un enroulement primaire 10 qui est le plus souvent constitué par un simple conducteur rectiligne. Le courant circulant dans l'enroulement secondaire 9 est mesuré par un ampèremètre A, lequel donne une indication proportionnelle au courant passant dans l'enroulement primaire 10.

Trois régimes de fonctionnement sont à discerner. Ils sont schématisés par la fig. 3.

a) Régime statique ou faiblement dynamique, de f0 à f1:

Dans ce cas l'amplificateur impose la relation fondamentale des transformateurs parfaits, étendue même pour les courants continus. le flux dans le noyau magnétique est nul, les ampère-tours parcourant l'enroulement secondaire sont égaux aux ampère-tours de l'enroulement primaire.

b) Régime de transition, de f1 à f3, délimité par les pôles P1 à P2:

La zone f1 à f2 est dûe à la caractéristique de transfert gainfréquence de l'amplificateur. La zone f2 à f3 est caractérisée par l'affaiblissement du signal secondaire aux basses fréquences dû à la présence de l'entrefer.

c) Régime dynamique de f3 à fx1:

L'ensemble se comporte comme un transformateur de courant.

La fig. 2 illustre schématiquement une forme d'exécution du capteur permettant des performances dynamiques beaucoup plus élevées. A cet effet, le capteur comprend deux noyaux magnétiques 11 et 12 de forme annulaire et disposés côte à côte. Le noyau 11 présente un entrefer 13 dans lequel est placé une cellule à effet HALL, telle que l'élément 3 de la figure 1. Cette cellule est alimentée par les batteries 4 et 5 et sa sortie attaque un amplificateur 8 à gain élevé. Le noyau 12 est éloigné du noyau 11 d'une valeur suffisante d pour éviter qu'il ne court-circuite magnétiquement le champ magnétique dans l'entrefer 2.

Le noyau ferromagnétique 12 ne comporte pas d'entrefer et il est dimensionné pour assurer une réponse correcte à partir d'une fréquence inférieure à f1 et jusqu'à une fréquence fx2 (Fig. 4).

En résumé, le pôle P2, correspondant à la fréquence de coupure inférieure du noyau ferromagnétique 12 et des enroulements, est situé à une fréquence plus basse que le pôle P1, correspondant à la fréquence de coupure de l'amplificateur. Ainsi, la fréquence de coupure de l'ensemble est linéaire de f0 à fx2 qui est supérieure à la fréquence fx1 du dispositif connu.

On peut, bien entendu, prévoir de nombreuses variantes d'exécution. En effet, les noyaux ferromagnétiques ne doivent pas nécessairement être de forme annulaire ni être disposés côte à côte. Selon une variante, un des noyaux pourrait être disposé à l'intérieur de l'autre, ce qui donne une construction compacte. Il est également possible de prévoir que le circuit magnétique 12 peut être constitué de deux noyaux ferromagnétiques disposés coaxialement et de part et d'autre du noyau 11 avec entrefer.

### Revendications

1. Capteur d'intensité pour courants continus et alternatifs, comprenant un circuit magnétique constitué par un noyau ferromagnétique (11) possédant un entrefer (2) et portant un enroulement primaire et secondaire (9, 10) un élément (3) à effet HALL étant sensible au champ magnétique régnant dans l'entrefer (13), cet élément (3) fournissant un signal électrique dépendant du champ magnétique, un amplificateur (8) contrôlé par ledit signal, cet amplificateur (8) alimentant l'enroulement secondaire (9) dans un sens tel qu'il tende à annuler le champ magnétique dû à l'enroulement primaire (10) et qui donne naissance audit signal électrique, un dispositif (A) de mesure de courant étant branché en série avec l'enroulement (9) alimenté par l'amplificateur (8), caractérisé en ce que le circuit magnétique comprend un deuxième noyau ferromagnétique (12) dépourvu d'entrefer, ce deuxième noyau (12) étant couplé magnétiquement au premier noyau ferromagnétique (1) par lesdits enroulements (9, 10).

2. Capteur selon la revendication 1, caractérisé en ce que les noyaux ferromagnétiques (11, 12) sont de forme annulaire, disposés coaxialement et espacés l'un de l'autre.

3. Capteur selon la revendication 2, caractérisé en ce que les noyaux ferromagnétiques (11, 12) présentent sensiblement les mêmes diamètres intérieurs et extérieurs et sont disposés côte à côte, l'enroulement (9) alimenté par l'amplificateur (8) formant une bobine à l'intérieur de laquelle passe au moins une portion de chaque noyau ferromagnétique (11, 12).

### Patentansprüche

1. Messfühler für die Stärke von Gleich- und Wechselströmen, mit einem Magnetkreis, der von einem ferromagnetischen Kern (11) gebildet ist, der einen Spalt (2) besitzt und eine Primär- und eine Sekundärwicklung (9, 10) trägt, mit einem für das Magnetfeld im Spalt (13) empfindlichen Hall-Element (3), das ein vom Magnetfeld abhängiges elektrisches Signal liefert, mit einem von diesem Signal gesteuerten Verstärker (8), der die Sekundärwicklung (9) derart speist, dass er das von der Primärwicklung (10) hervorgerufene, zur Entstehung des elektrischen Signals führende Magnetfeld zu Null zu machen sucht, und mit einer Strommesseinrichtung (A), die mit der von dem Verstärker (8) gespeisten Wicklung (9) in Reihe geschaltet ist, dadurch gekennzeichnet, dass der Magnetkreis einen zweiten ferromagnetischen, luftspaltlosen Kern (12) enthält, der mit dem ersten ferromagnetischen Kern (1) durch die Wicklungen (9, 10) magnetisch gekoppelt ist.

2. Messfühler nach Anspruch 1, dadurch gekennzeichnet, dass die ferrogmagnetische Kerne (11, 12) ringförmig, koaxial und mit Abstand zueinander angeordnet sind.

3. Messfühler nach Anspruch 2, dadurch gekennzeichnet, dass die ferromagnetischen Kerne (11, 12) etwa dieselben inneren und äusseren Durchmesser aufweisen und Seite an Seite angeordnet sind, und dass die von dem Verstärker (8) gespeiste Wicklung (9) eine Spule bildet, deren Inneres wenigstens ein Abschnitt jedes ferromagnetischen Kerns (11, 12) durchsetzt.

### Claims

1. A device for sensing the magnitude of direct and alternating currents, comprising a magnetic circuit constituted by a ferromagnetic core (11) having an air gap (2) and carrying a primary and secondary winding (9, 10), a Hall effect element (3) sensitive to the magnetic field in the air gap (13), the said element (3) supplying an electrical signal dependent on the magnetic field, an amplifier (8) controlled by the said signal, the said amplifier (8) supplying the secondary winding (9) in a direction such that it tends to oppose the magnetic field due to the primary winding (10) and to generate the said electrical signal, a current measuring device (A) being connected in series with the winding (9) supplied by the amplifier (8), characterised in that the magnetic circuit includes a second ferromagnetic core (12) having no air gap, the said second core (12) being magnetically coupled to the first ferromagnetic core (1) through the said windings (9, 10).

2. A device according to Claim 1, characterised in that the ferromagnetic cores (11, 12) are of annular form, disposed coaxially and spaced from each other.

3. A device according to Claim 2, characterised in that the ferromagnetic cores (11, 12) have substantially the same internal and external diameters and are arranged side by side, the winding (9) supplied by the amplifier (8) being wound in a bobbin-like configuration with at least a portion of each ferromagnetic core (11, 12) extending through the interior of the bobbin.

FIG.1

FIG.2

FIG.3

FIG.4